## Europäisches Patentamt
## European Patent Office
## Office européen des brevets

(19)

(11) Publication number: **0 030 117**
**B1**

(12)

# EUROPEAN PATENT SPECIFICATION

(45) Date of publication of patent specification: **07.09.83**

(51) Int. Cl.³: **H 01 L 21/312**

(21) Application number: **80304233.2**

(22) Date of filing: **26.11.80**

(54) Method of forming an opening in a negative resist film.

(30) Priority: **28.11.79 JP 154013/79**

(43) Date of publication of application:
**10.06.81 Bulletin 81/23**

(45) Publication of the grant of the patent:
**07.09.83 Bulletin 83/36**

(84) Designated Contracting States:
**DE FR GB NL**

(56) References cited:
**DE - A - 2 143 737**
**DE - A - 2 346 719**
**DE - A - 2 502 591**
**DE - A - 2 655 455**
**DE - A - 2 744 837**
**DE - A - 2 752 900**
**DE - A - 2 835 868**
**GB - A - 1 112 405**

(73) Proprietor: **FUJITSU LIMITED**
**1015, Kamikodanaka Nakahara-ku**
**Kawasaki-shi Kanagawa 211 (JP)**

(72) Inventor: **Yamanouchi, Kazuaki**
**913, Kamikodanaka Nakahara-ku**
**Kawasaki-shi Kanagawa 211 (JP)**

(74) Representative: **Bedggood, Guy Stuart et al,**
**Haseltine Lake & Co. Hazlitt House 28**
**Southampton Buildings Chancery Lane**
**London WC2A 1AT (GB)**

Courier Press, Leamington Spa, England.

# Method of forming an opening in a negative resist film

The present invention is directed to a method of forming an opening in a negative resist film.

In recent years, semiconductor devices have become highly integrated and, keeping pace therewith, unit elements in semiconductor chips manufactured by advanced technology have come miniaturized to an extreme degree. Various patterns employed in the manufacture of such chips are accordingly prepared so as to be very minute.

It is general practice in the industry to utilise photoresist light sensitive emulsion in the formation of various impurity diffusion and electrode contact regions in the manufacture of semiconductor devices. The photoresist emulsion is coated on the surface of an oxidised silicon slice or wafer, for example, the slice is then baked to remove solvents. A photographic mask is accurately aligned using a jig, and is placed in contact with the photoresist film formed by the emulsion which film is then partially exposed to ultraviolet light through the mask. Using a photoresist developer, desired patterns are formed in the photoresist film. Using such a patterned photoresist film, a silicon oxide (or silicon nitride) film formed on the surface of the silicon slice is selectively removed to form an impurity diffusion mask for example or to define contact regions.

There are two types of photoresist light sensitive emulsions. One is a negative type, the photoresist emulsion having the property of becoming less soluble in its developer wherever it is polymerized by exposure to ultraviolet radiation. Unexposed areas of emulsion under opaque parts of the photographic mask (which are coated with chrome for example) can be selectively removed with the photoresist developer. The resist remaining after developing is usually hardened through post-baking and acts as a convenient mask through which the oxide (or nitride) layer can be etched away.

On the other hand, there is the other type of photoresist emulsion, namely positive emulsion which is utilized in a similar manner. However, windows are opened in a positive photoresist wherever the photographic mask is transparent, because it is the property of positive photoresists that areas exposed to ultraviolet light become soluble and can be removed by a photoresist developer.

Negative photoresist emulsions can be processed more quickly than positive photoresist emulsions in most cases.

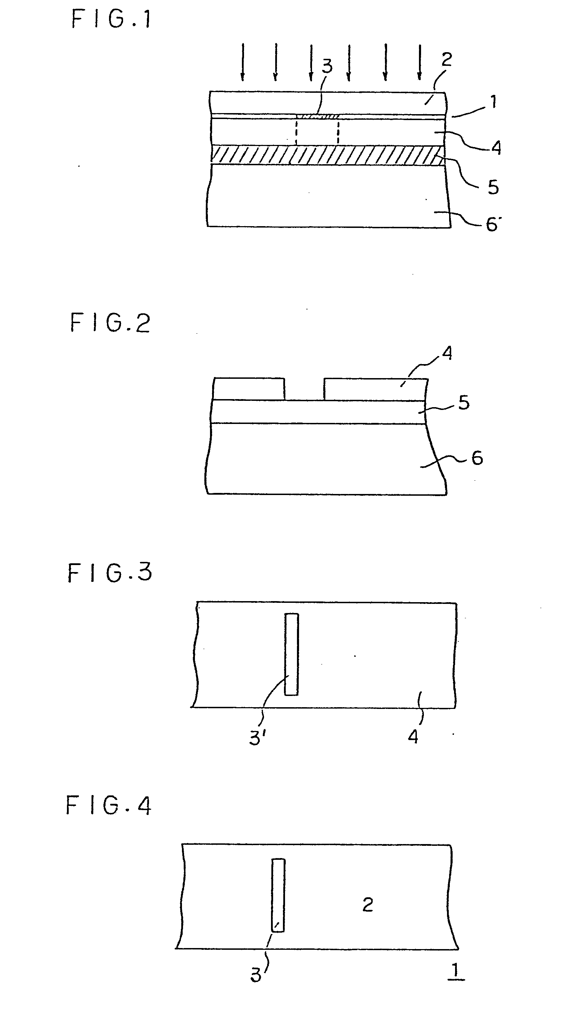

Figure 1 of the accompanying drawings is a schematic cross-sectional view showing one mode of carrying out a conventional method of forming patterns.

A photographic mask 1 made of transparent glass 2 has on a surface thereof a pattern provided by opaque material 3, chrome for example. The mask 1 is placed on a photoresist film 4 on an oxide layer 5 formed on a semiconductor substrate 6. By irradiating with light from above, areas of the film 4 other than the area thereof beneath the pattern of opaque material 3 on mask 1 are exposed to light, the area beneath the pattern remaining unexposed.

Unexposed photoresist is removed by a developer, which, for example, mainly comprises xylene, and a photoresist film 4 having a pattern as shown in Figure 2 of the accompanying drawings, which is also a schematic cross-sectional view, is formed on the oxide layer 5. After a subsequent etching process, only parts of the oxide layer 5 conforming to the desired pattern remain on the semiconductor substrate 6, and diffusion and formation of contacts are then effected to provide a semiconductor device.

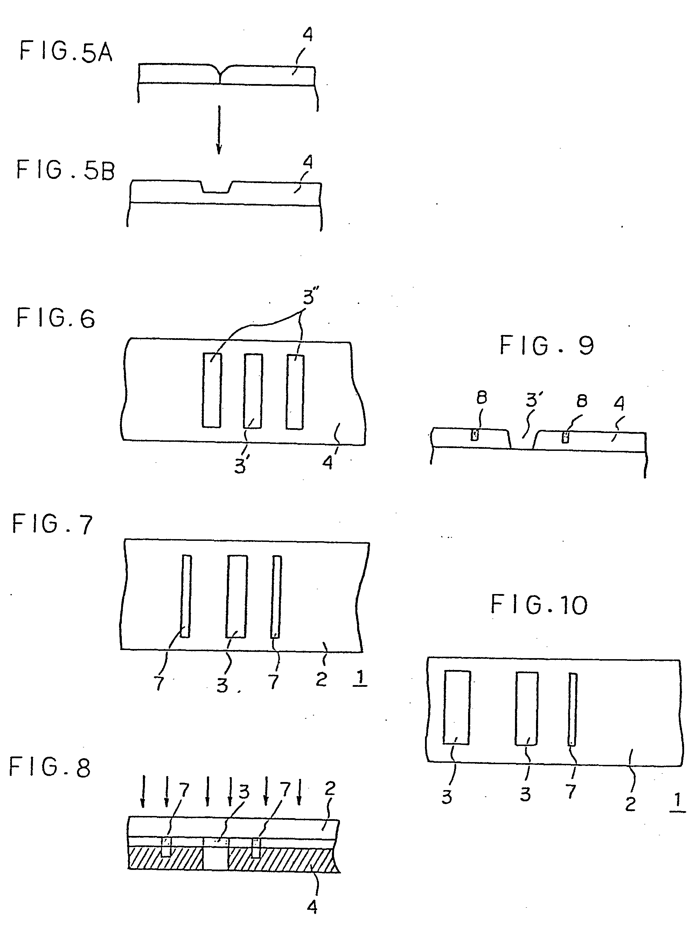

Often, it becomes necessary to prepare through a photoresist film 4 a very narrow opening or window 3' as shown in Figure 3 of the accompanying drawings, which is a schematic plan view. Recent demands for miniaturization of integrated circuits often require that the lateral width of the opening as seen in Figure 3 be less than 3 $\mu$m. In such a case, a photographic mask 1 (shown in schematic plan view in Figure 4 of the accompanying drawings) having a plate 2 with an opaque pattern 3 which corresponds to the opening 3' of Figure 3 is generally used in a manner illustrated in Figure 1. With any conventional negative photoresist, for example, a negative photoresist in the family of isopropylene, so-called swelling of the photoresist occurs during the development process because the exposed and polymerised photoresist is essentially soluble in the developer. Ordinarily, such a swelling is caused to shrink by the use of a rinsing solution, for example, butyl acetate, and a desired photoresist pattern opening can be prepared. If the width of the pattern opening is extremely narrow, however, photoresist from opposite sides of the opening in the resist adheres together at the time of development as shown in the schematic cross-sectional view of Figure 5A of the accompanying drawings. Even if the rinsing solution is used thereafter, the photoresist does not separate, the result is as shown in the schematic cross-sectional view of Figure 5B. As a result, the opening is obliterated or burr-like parts are formed.

This swelling of the photoresist depends on the thickness of the photoresist and the area. Accordingly, where the width of an opening to be formed in the photoresist film is approximately 3 $\mu$m, with the thickness of the photoresist being in the order of 800 to 1000 nm (8,000 to 10,000Å), the pattern is lost or burr-like parts appear if the opening 3' is isolated far from other openings of the photoresist film as illustrated in Figure 3, due to swelling of the photoresist.

DE—A—2 143 737 discloses a photo etching method in which faults, arising from defects in photo masks, can be avoided.

DE—A—2 143 737 discloses a method of forming a photoresist pattern by multiple partial exposures of a photoresist layer using a plurality of photo masks. For example, in a first mask, defects are present including an opaque defect present in a transparent mask area, neighbouring an opaque mask area in which a transparent defect is present. On a first partial exposure using the first mask, a region of the photoresist corresponding to the opaque mask area provides a first unexposed portion and a region of the photoresist corresponding to the opaque defect provides a second (wrongly) unexposed portion. In the opaque mask area the transparent defect leads to a wrongly exposed area. After the first partial exposure the first mask is removed and replaced by a corresponding second mask. Provided that no defect in the second mask registers with a defect in the first mask, upon a second partial exposure the wrongly exposed area (corresponding to the transparent defect) is not exposed, whilst the second (wrongly) unexposed area corresponding to the opaque defect) is partially exposed. If the photoresist is a negative resist and is etched following the second partial exposure the photoresist is not punctured at the wrongly exposed area (corresponding to the transparent defect) and no corresponding fault appears in the photoresist. However, the second (wrongly) unexposed area (corresponding to the opaque defect) leads to removal of corresponding photoresist upon etching, and hence leads to a fault in the etched photoresist. By using more than two partial exposures before etching of the photoresist, a fault in the photoresist arising from the second (wrongly) unexposed area (corresponding to the opaque defect) can be avoided. The energies of the partial exposures must be suitable selected.

According to the present invention there is provided a method of forming an opening in a negative resist film, comprising exposing the negative resist film in such a way as to leave first and second unexposed portions in the resist film, the first unexposed portion corresponding to the opening to be formed, and the second unexposed portion being disposed proximately to the first unexposed portion, and developing the resist film, thereby selectively to remove the first and second unexposed portions, characterised in that the second unexposed portion is formed as a false pattern having a width small enough, and/or a depth shallow enough, that a swelling effect occurring in the resist in developing prevents formation of a throughhole thereat in developing of the resist, and in that the first unexposed portion of the resist film is formed as a real pattern, the said opening being formed in correspondence to the first unexposed portion, the second unexposed portion being so proximate to the first unexposed portion as to take up swelling occurring thereat in the resist in developing the resist.

In the course of investigation of the adverse effects of swelling of photoresist as described above, it was found that, if there are other openings 3″ near an opening 3′ as shown in Figure 6 of the accompanying drawings, which is a schematic plan view, swelling of the photoresist can be absorbed in these openings 3″, and this can serve to prevent problems such as obliteration of the opening 3′ mentioned above.

An embodiment of the present invention provides a method of forming a fine opening in a negative resist film without obliteration of the opening or formation of burr-like parts as experienced previously and so without the consequent tendency to present difficult problems as described above in cases in which minute patterns must be formed in areas as shown in Figure 3.

An embodiment of the present invention can provide a method for forming a fine opening in a negative resist film without complicating the process as compared to a conventional process.

For example, in an embodiment of the invention, a conventional negative photoresist is used, the photoresist is exposed to ultraviolet light through a photographic mask, and the photoresist is developed and rinsed. The photographic mask is prepared, in accordance with the invention, in such a manner that there is provided, in addition to a real pattern corresponding to a desired opening to be formed in the photoresist, at least one false pattern, in the neighborhood of the real pattern, the or each such false pattern having a width such that a through-hole cannot be formed in the photoresist film in correspondence to the false pattern as a result of the effect of light circling around under the false pattern at the time of exposure to light and/or the effect of swelling of the photoresist.

Reference is made, by way of example, to the accompanying drawings, in which:—

Figures 1 to 4 are cross-sectional and plan views for assistance in explanation of previous methods of patterning a photoresist film;

Figures 5A and 5B are cross-sectional views which illustrate problems experienced with previous methods; and

Figures 6 to 10 are plan and cross-sectional views for assistance in explanation of methods embodying the present invention.

To carry out a preferred embodiment of the present invention, a photographic mask as shown in Figure 7 is used. In this mask, there are formed, in the neighborhood of a real pattern 3 which corresponds to a desired opening to be formed in a photoresist film, false patterns 7 of a width much narrower than that of real pattern 3. In the industry, the minimum width of the real pattern 3 is currently in the order of 2 to 3 $\mu$m. The width of each of the false patterns 7 should preferably be in the range of less than, or at the most equal to, 1 $\mu$m so that, at the time of exposure to light, light would, having regard to the thickness of photoresist, circle around beneath the false pattern 7 due to a diffraction effect, thus preventing formation of the through-hole in the photoresist film. Where the real pattern 3 has a width in the order of 2 to 3 $\mu$m as described above to meet requirements for highly packed integrated circuits, the thickness of photoresist film would be in the range 800 to 1000 nm (8,000 to 10,000 Å). It would be very difficult to prepare the photoresist film thinner than this if formation of pinholes is to be prevented.

In the foregoing description, the terms "real pattern" and "false pattern" are used to denote the fact that whereas the pattern 3 is provided to function for forming an opening or window in a photoresist film in the sense now understood in the art, the patterns 7 are provided only for the purpose of dealing with swelling of the photoresist, and there should appear no corresponding openings that go through the photoresist. These terms are to be understood in this sense.

Exposure of photoresist to light is carried out as shown in Figure 8 using the photographic mask just described. Figure 8 is generally similar to Figure 1, but for the purpose of clarification, the semiconductor substrate and the oxide film thereon have been omitted. In Figure 8, it should be understood that, of the negative photoresist film 4, hatched parts are the parts exposed to light and the parts without hatching are the parts not exposed. The photoresist beneath the pattern 3 is entirely unexposed. However, photoresist beneath each pattern 7 has an unexposed portion immediately below the pattern 7 and a portion beneath this unexposed portion that is exposed to light by reason of light circling around beneath the unexposed part or light diffraction. And thus, as illustrated in Figure 9, part 3' of photoresist corresponding to pattern 3 is removed, but parts 8 of the photoresist corresponding to pattern 7 are only partially removed in the developing process, and formation of throughholes in the photoresist film in correspondence with those patterns 7 is avoided. Swelling of the photoresist during development as described above is absorbed in the partially removed parts 8, which effectively decreases the change in size of the window 3' due to swelling of the photoresist. As a result, obliteration of a pattern opening or formation of burrlike parts at part 3' is prevented. After development, a rinsing process may be carried out.

The width of each false pattern 7 prepared in accordance with this embodiment of the invention is so determined as to allow light to circle around beneath it in order to provide a partially exposed photoresist. A width in the order of 1 $\mu$m is preferable in current practice. Partially exposed photoresist parts are not absolutely necessary provided that through holes are not formed in the photoresist as a result of exposure to light, development and rinsing.

In other words, that part of the photoresist corresponding to a false pattern (i.e. below a false pattern) may remain entirely unexposed (i.e. unexposed throughout its depth) if it is so narrow that swelling of the photoresist in a succeeding development process obliterates the unexposed false pattern and thus prevents formation of a through-hole even after the rinsing step.

Patterns 7 are formed near the pattern 3 as illustrated in Figure 7. In the embodiment shown, the width of the pattern 3 (the width of the opening to be formed) is in the order of 2 to 3 $\mu$m, the distance or space between the patterns 3 and 7 is in the range 2 to 15 $\mu$m. If the distance is less than 2 $\mu$m, the thickness of the photoresist film between the patterns 3 and 7 becomes small, and the photoresist film in that region does not properly perform the functions of a photoresist film. If the distance is more than 15 $\mu$m, the desired effect of suppression of swelling could hardly be expected. The most preferable range of distance is 5 to 7 $\mu$m in this embodiment. These values are selected relative to a photoresist film having a thickness in the order of 800 to 1000 nm (8,000 to 10,000 Å), as is now generally used in the industry. If the photoresist film is thicker, the distance in question should be made shorter.

Experiments have confirmed that the effectiveness of a false pattern according to the present invention depends on the distance $d$ between the false and real patterns in relation to the width $w$ of the real pattern, and the preferable range of the distance $d$ is from $w$ to $5w$. The most preferable range of the distance $d$ is $2w$ to $3w$. A false pattern may be omitted when there is another window pattern within a suitable distance from the real window pattern. For example, where two real window patterns 3 are formed proximately as shown in Figure 10, only one false pattern 7 need be formed, to one side of one window pattern 3 opposite to the side of that one window pattern at which the other pattern 3 is formed.

It is a remarkable advantage of a method embodying the present invention that it does not require any additional process step which would complicate the manufacturing process whilst nevertheless assuring formation of a minute window in a negative photoresist.

In the foregoing description, the negative photoresist has been described as being exposed to light, usually ultraviolet light. However, embodiments of the present invention are not limited only to cases where ultraviolet light is employed. Where an energy beam, such as an X-ray or an electron beam, is used methods embodying the present invention can be just as effective as when ultraviolet light is employed. When an X-ray or electron beam is employed in an exposure process, diffraction effects are negligible because the wavelength of X-ray or electron beam energy is much shorter than that of ultraviolet light. In order to carry out a method embodying the present invention with an X-ray or electron beam exposure process, unexposed portions of a negative X-ray or electron beam resist corresponding to a false pattern as described above are provided near an unexposed portion where a window is to be formed. In this case, the false unexposed pattern disappears during the development process, absorbing the swelling of the resist.

In methods embodying the present invention, in an exposure process, near a real pattern a false pattern is provided which is formed very minutely so that the false pattern substantially disappears in the developed resist film while absorbing the swelling of the resist occurring during the development process.

Thus, a method embodying the present invention enables formation of finely patterned openings or windows in a photoresist film such as is much sought after in the manufacture of highly packed integrated circuits. In addition, the fact that minutely patterned openings can be formed as designed contributes substantially in improving reliability of the manufactured semiconductor devices.

In embodiments of this invention, for forming very minute windows or openings in a negative photoresist film as required in the manufacture of highly packed semiconductor devices, false unexposed patterns are formed in proximity to the minute real unexposed patterns, the false patterns being of such width that, when developed after exposure to ultraviolet light or an energy beam, photoresist film immediately below false patterns is unexposed but photoresist under the unexposed parts thus provided is exposed to light by reason of light circling around under the false pattern, with a result that the false patterns in the photoresist film substantially disappears after development. Such partially removed false patterns serve to negate swelling of the photoresist at the time of development and prevent obliteration of real windows or openings or formation of burr-like parts where real windows or openings are to be formed.

The photoresist under a false pattern may be unexposed through its entire depth provided that the pattern is so fine that swelling of the resist prevents formation of an opening corresponding to the false pattern during development.

## Claims

1. A method of forming an opening in a negative resist film, comprising exposing the negative resist film in such a way as to leave first and second unexposed portions in the resist film, the first unexposed portion corresponding to the opening to be formed, and the second unexposed portion being disposed proximately to the first unexposed portion, and developing the resist film, thereby selectively to remove the first and second unexposed portions, characterised in that the second unexposed portion is formed as a false pattern having a width small enough, and/or a depth shallow enough, that a swelling effect occuring in the resist in developing prevents formation of a through-hole thereat in developing of the resist, and in that the first unexposed portion of the resist film is formed as a real pattern, the said opening being formed in correspondence to the first unexposed portion, the second unexposed portion being so proximate to the first unexposed portion as to take up swelling occurring thereat in the resist in developing of the resist.

2. A method as claimed in claim 1, wherein the second unexposed portion extends only part way through the thickness of the resist film.

3. A method as claimed in claim 1, wherein the second unexposed portion extends completely through the resist film,

4. A method as claimed in claim 1, 2 or 3, further comprising rinsing the resist film after developing.

5. A method as claimed in any preceding claim, wherein distance $d$ between the first portion, having a width $w$, and the second portion, is in the range $w$ to $5w$.

6. A method as claimed in any preceding claim, wherein the resist film is exposed to ultraviolet light through a photographic mask.

7. A method as claimed in any preceding claim, wherein distance $d$ between the first and second portions is in the range $2\ \mu m$ to $15\ \mu m$.

8. A method as claimed in claim 7, wherein the thickness of the resist film is in the range 800 to 1000 nm (8000 Å to 10000 Å).

9. A method as claimed in claim 3, wherein the resist film is exposed to X-ray beam energy.

10. A method as claimed in claim 3, wherein the resist film is exposed to electron beam energy.

## Revendications

1. Procédé pour former une ouverture dans un film de photorésist négatif, consistant à exposer le film de photorésist négatif de manière à laisser des première et seconde parties non exposées dans le film de photorésist, la première partie non exposée correspondant à l'ouverture à former et la seconde partie non exposée étant disposée à proximité de la première partie non exposée, et à développer le film de photorésist, afin d'éliminer sélectivement les première et seconde parties non exposées, caractérisé en ce que la seconde partie non exposée est formée comme une fausse configuration ayant une largeur suffisamment petite et/ou une profondeur suffisamment réduite pour qu'un effet de gonflement apparaissant dans le photorésist au développement évite la formation d'un trou de traversée à cet endroit pendant le développement du photorésist, et en ce que la première partie non exposée du film de photorésist est formée comme une configuration réelle, ladite ouverture étant formée en correspondance avec la première partie non exposée, la seconde partie non exposée étant suffisamment proche de la première partie non exposée pour absorber le gonflement qui s'y produit dans le photorésist à son développement.

2. Procédé selon la revendication 1, dans lequel la seconde partie non exposée ne s'étend qu'en partie dans l'épaisseur du film de photorésist.

3. Procédé selon la revendication 1, dans lequel la seconde partie non exposée s'étend complètement à travers le film de photorésist.

4. Procédé selon la revendication 1, 2 ou 3, comprenant en outre un rinçage du film de photorésist après de développement.

5. Procédé selon l'une quelconque des revendications précédentes danslequel la distance $d$ entre la première partie, ayant une largeur $w$ et la seconde partie est dans la plage de $w$ à $5w$.

6. Procédé selon l'une quelconque des revendications précédentes, dans lequel le film de photorésist est exposé à de la lumière ultraviolette à travers un masque photographique.

7. Procédé selon l'une quelconque des revendications précédentes, dans lequel la distance $d$ entre les première et seconde parties est dans la plage de 2 $\mu$m à 15 $\mu$m.

8. Procédé selon la revendication 7, dans lequel l'épaisseur du film de photorésist est dansla plage de 800 à 1000 nm (800 Å à 10 000 Å).

9. Procédé selon la revendication 3, dans lequel le film, de photorésist est exposé à l'énergie d'un faisceau de rayons X.

10. Procédé selon la revendication 3, dans lequel le film de photorésist est exposé à l'énergie d'un faisceau d'électrons.

**Patentansprüche**

1. Verfahren zur Bildung einer Öffnung in einem negativen Resistfilm, bei welchem der negative Resistfilm in solch einer Weise belichtet wird, daß ein erster und ein zweiter unbelichteter Abschnitt auf dem Resistfilm verbleiben, von denen der erste unbelichtete Abschnitt der zu bildenden Öffnung entspricht und der zweite unbelichtete Abschnitt nahe dem ersten unbelichteten Abschnitt angeordnet ist, und bei welchem der Resistfilm entwickelt wird, um dadurch wahlweise den ersten und den zweiten unbelichteten Abschnitt zu entfernen, dadurch gekennzeichnet, daß der zweite unbelichtete Abschnitt als ein falsches Muster mit einer Breite, die hinreichend klein ist, und oder einer Tiefe, die hinreichend flach ist, ausgebildet wird, daß ein beim Entwickeln in dem Resistfilm auftretender Schwelleffekt die Bildung eines hindurchgehenden Loches verhindert, und daß der erste unbelichtete Abschnitt des Resistfilms als ein reales Muster ausgebildet wird, wobei die genannte Öffnung entsprechend dem ersten unbelichteten Abschnitt geformt wird und der zweite unbelichtete Abschnitt so nahe bei dem ersten unbelichteten Abschnitt liegt, daß er die dort bei der Entwicklung des Resistfilms auftretende Schwellung aufnimmt.

2. Verfahren nach Anspruch 1, dadurch gekennzeichnet, daß der zweite unbelichtete Abschnitt sich nur teilweise durch die Dicke des Resistfilms erstreckt.

3. Verfahren nach Anspruch 1, dadurch gekennzeichnet, daß der zweite unbelichtete Abschnitt sich vollständig durch den Resistfilm hindurcherstreckt.

4. Verfahren nach Anspruch 1, 2 oder 3, dadurch gekennzeichnet, daß der Resistfilm nach dem Entwickeln gespült wird.

5. Verfahren nach einem der vorhergehenden Ansprüche, dadurch gekennzeichnet, daß der Abstand $d$ zwischen dem ersten Abschnitt, welcher die Breite $w$ hat, und dem zweiten Abschnitt, im Bereich zwischen $w$ und $5w$ liegt.

6. Verfahren nach einem der vorhergehenden Ansprüche, dadurch gekennzeichnet, daß der Resistfilm durch eine photographische Maske mit ultraviolettem Licht belichtet wird.

7. Verfahren nach einem der vorhergehenden Ansprüche, dadurch gekennzeichnet, daß der Abstand $d$ zwischem dem ersten und dem zweiten Abschnitt im Bereich zwischen 2 $\mu$m und 15 $\mu$m liegt.

8. Verfahren nach Anspruch 7, dadurch gekennzeichnet, daß die Dicke des Resistfilms im Bereich von 800 bis 1000 nm (800 Å bis 10000 Å) liegt.

9. Verfahren nach Anspruch 3, dadurch gekennzeichnet, daß der Resistfilm mit Röntgenstrahlenenergie belichtet wird.

10. Verfahren nach Anspruch 3, dadurch gekennzeichnet, daß der Resistfilm mit Elektronenstrahlenenergie belichtet wird.

FIG.1

FIG.2

FIG.3

FIG.4

FIG.5A

4

FIG.5B

4

FIG.6

3"

3'

4

4

FIG.9

8    3'    8    4

FIG.7

7    3    7    2    1

FIG.10

FIG.8

7    3    7    2

4

3    3    7    2    1